# EUROPEAN PATENT APPLICATION

(11) **EP 4 826 118 A1**
(43) Date of publication of application: **21.10.2026**
(21) Application number: 26163238.4
(22) Date of filing: 09.03.2026
(51) Int. Cl.: C23C 16/455, C23C 16/40

(54) **AZEOTROPIC MIXTURE, METHOD OF DEPOSITING THIN FILM, AND SEMICONDUCTOR SUBSTRATE AND SEMICONDUCTOR DEVICE FABRICATED THEREFROM**

(30) Priority: 15.04.2025 KR 20250048873; 30.10.2025 KR 20250160661
(71) Applicant: Soulbrain Co., Ltd., Seongnam-si, Gyeonggi-do 13486 (KR)
(72) Inventor: LEE, Seung Hyun, 13486 Gyeonggi-do (KR); JUNG, Jae Sun, 13486 Gyeonggi-do (KR); KIM, Deok Hyun, 13486 Gyeonggi-do (KR); PARK, Ji Won, 13486 Gyeonggi-do (KR); KIM, Sung Gi, 13486 Gyeonggi-do (KR)
(74) Representative: Dehns

(57) **Abstract**

The present invention relates to an azeotropic mixture, a method of depositing a thin film, and a semiconductor substrate and semiconductor device fabricated therefrom. According to the present invention, the present invention has an effect of providing an azeotropic mixture in which a volatility modifier is blended with a precursor compound having high pyrophoricity among precursor compounds used for forming a thin film on a substrate to provide the azeotropic mixture, whereby volatility of the precursor compound may be controlled so that injecting the precursor compound into a chamber in a vapor state is facilitated, depositing a thin film precisely is facilitated by reducing a deposition rate, and impurities do not remain in the thin film; a method of depositing a thin film using the same; and a semiconductor substrate and semiconductor device fabricated therefrom.

## Description

### [Technical Field]

The present invention relates to an azeotropic mixture, a method of depositing a thin film, and a semiconductor substrate and semiconductor device fabricated therefrom. More particularly, the present invention relates to an azeotropic mixture in which a volatility modifier is blended with a precursor compound having high pyrophoricity among precursor compounds used for forming a thin film on a substrate to provide the azeotropic mixture, whereby volatility of the precursor compound may be controlled so that injecting the precursor compound into a chamber in a vapor state is facilitated, depositing a thin film precisely is facilitated by reducing a deposition rate, and impurities do not remain in the thin film; a method of depositing a thin film using the same; and a semiconductor substrate and semiconductor device fabricated therefrom.

### [Background Art]

Aluminum precursors or zinc precursors are widely used in fields such as semiconductors, displays, solar cells, and secondary batteries, and representative examples thereof include trimethyl aluminum (TMA), triethyl aluminum (TEA), dimethyl zinc (DMZ), diethyl zinc (DEZ), trimethyl gallium (TMG), triethyl gallium (TEG), trimethyl indium (TMI), and triethyl indium (TEI).

Although the aluminum precursors or zinc precursors have reasonable prices and excellent performance, the aluminum precursors or zinc precursors are difficult to handle because the aluminum precursors or zinc precursors exhibit pyrophoricity due to high pyrophoricity, so attempts to develop low-risk organometallic precursors are continuing to implement low pyrophoricity or non-pyrophoricity.

However, the developed low-risk Al precursors are more expensive than conventional TMA precursors because ligands bonded to Al, which is a central metal, are complex, and there is a technical problem in that impurities such as carbon and nitrogen remain in a thin film.

For example, a commercially available low-risk Al precursor may have the following structure.

### [Example of low-risk Al precursor]

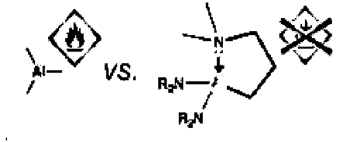

Therefore, development of a technology capable of stabilizing highly flammable precursors represented by trimethyl aluminum (TMA), triethyl aluminum (TEA), dimethyl zinc (DMZ), diethyl zinc (DEZ), trimethyl gallium (TMG), triethyl gallium (TEG), trimethyl indium (TMI), and triethyl indium (TEI) is still required.

### [Related Art Documents]

### [Patent Documents]

KR 2011-0027488 A

### [Disclosure]

### [Technical Problem]

Therefore, the present invention has been made in view of the above problems, and it is one object of the present invention to provide an azeotropic composition in which a volatility improver is blended with a precursor compound having high pyrophoricity among precursor compounds used for forming a thin film on a substrate to control volatility of the precursor compound, thereby facilitating injection into a chamber in a vapor state, facilitating precise deposition of a thin film by reducing a deposition rate, and ensuring impurities do not remain in the thin film.

It is another object of the present invention to provide a method of depositing a thin film, in which an azeotropic mixture is provided to control volatility of the precursor compound, thereby not only facilitating injection into a chamber in a vapor state but also facilitating precise deposition of a thin film by reducing a deposition rate, and ensuring impurities do not remain in the thin film, and semiconductor substrate and semiconductor device fabricated therefrom.

The above and other objects can be accomplished by the present invention described below.

### [Technical Solution]

In accordance with one aspect of the present invention, provided is an azeotropic mixture including a precursor compound having spontaneous pyrophoricity at room temperature; and a volatility modifier,
wherein a central metal of the precursor compound is aluminum, zinc, gallium, or indium, and
the volatility modifier is a material controlling volatility of the precursor compound and includes one or more compounds selected from a cyclic compound having 3 or more element species having a lone pair of electrons and a linear compound having 3 or more element species having a lone pair of electrons.

The precursor compound may include one or more selected from trimethyl aluminum (TMA), triethyl aluminum (TEA), dimethyl zinc (DMZ), diethyl zinc (DEZ), trimethyl gallium (TMG), triethyl gallium (TEG), trimethyl indium (TMI), and triethyl indium (TEI).

The lone pair of electrons may include one or more selected from oxygen (O), sulfur (S), phosphorus (P), and nitrogen (N).

The cyclic compound having 3 or more element species having a lone pair of electrons may be a compound represented by Chemical Formula 1 below. 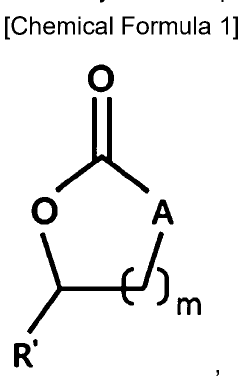
wherein R' is hydrogen, an alkyl group having 1 to 5 carbon atoms, an alkenyl group having 1 to 5 carbon atoms, or an alkoxy group having 1 to 5 carbon atoms,
A is oxygen (O), sulfur (S), phosphorus (P), or nitrogen (N), and
m is an integer of 0 to 2.

The linear compound having 3 or more element species having a lone pair of electrons may be a compound represented by Chemical Formula 2 below. 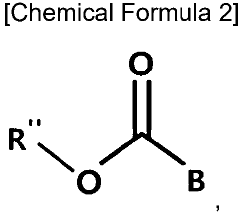
wherein R" is hydrogen, an alkyl group having 1 to 5 carbon atoms, an alkenyl group having 1 to 5 carbon atoms, or an alkoxy group having 1 to 5 carbon atoms, and
B is -OH, -OCH₃, -OCH₂CH₃, -CH₂CH₃, -SH, -SCH₃, or -SCH₂CH₃.

The volatility improver may include one or more compounds selected from compounds represented by Chemical Formulas 1-1 to 1-3 below and compounds represented by Chemical Formulas 2-1 to 2-3 below.

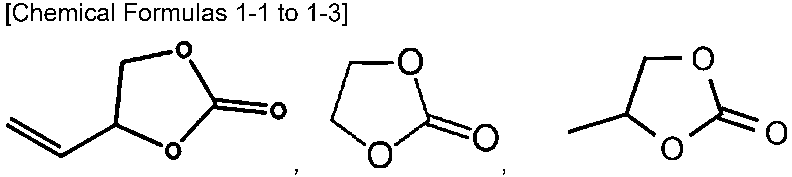

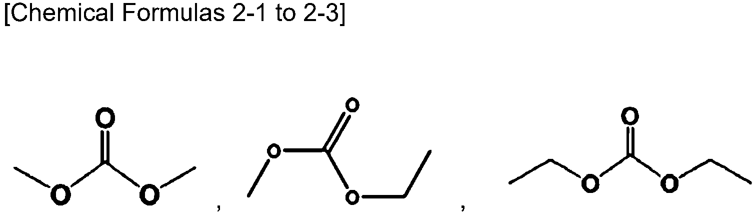

The precursor compound and the volatility improver may be included in a molar ratio of 1:0.5 to 5.

The azeotropic mixture may have a boiling point of 40 to 180 °C under normal pressure.

The azeotropic mixture may have a turbidity (haze) of 10 or less.

The azeotropic mixture may have a viscosity of 50 cP or less.

The azeotropic mixture may have a T₀ value of 200 °C or less.

The azeotropic mixture may have a vapor pressure of 0.1 Torr or more at 20 °C.

In accordance with another aspect of the present invention, provided is a method of depositing a thin film, including stacking one or more thin films using the azeotropic mixture described above.

The method of depositing a thin film may include injecting an azeotropic mixture onto a substrate loaded into a chamber to control spontaneous pyrophoricity of a precursor compound; injecting an inert gas into the chamber to remove an unreacted azeotropic mixture and by-products; injecting a nitriding gas, an oxidizing gas, or a reducing gas into the chamber to form a nitride film, oxide film, or metal film of a central metal included in the precursor compound; and injecting an inert gas into the chamber to remove unreacted gas and by-products.

The chamber may be an ALD chamber, a CVD chamber, a PEALD chamber, or a PECVD chamber.

The substrate may be heated to 100 to 700 °C.

The deposition may be performed at 100 to 700 °C.

The thin film may be formed by stacking an aluminum nitride film, an aluminum oxide film, an aluminum metal film, a zinc nitride film, a zinc oxide film, a zinc metal film, a gallium oxide film, a gallium nitride film, a gallium metal film, an indium oxide film, an indium nitride film, or an indium metal film. A representative deposition film may be IGZO (InGaZnO).

In accordance with still another aspect of the present invention, provided is a thin film formed by the method of depositing a thin film described above, characterized in that the thin film is a thin film formed by stacking a nitride film, oxide film, or metal film of a central metal.

In the oxide film, a ratio of at least one Group 13 central metal selected from Al, Ga, and In/O (oxygen) as measured by AES may be within a range of 0.6 to 0.75.

In the oxide film, a ratio of a Group 12 central metal of Zn/O (oxygen) as measured by AES may be within a range of 0.45 to 0.55.

In accordance with still another aspect of the present invention, provided is a semiconductor substrate including the thin film described above.

In accordance with yet another aspect of the present invention, provided is a semiconductor device including the semiconductor substrate described above. The semiconductor device corresponds to memory (DRAM, 3D-DRAM, NAND) and logic (CPU, GPU, AP), and the present invention is not limited thereto.

### [Advantageous Effects]

According to the present invention, the present invention has an effect of providing an azeotropic mixture which is easy to handle by implementing low pyrophoricity or non-pyrophoricity, facilitates injection into a chamber in a vapor state while using conventional deposition equipment without modification, facilitates precise deposition of a thin film by reducing a deposition rate, and ensures that impurities do not remain in the thin film.

In addition, the present invention has an effect of providing a method of depositing a thin film, characterized in that the method controls volatility of a precursor compound by using the azeotropic mixture of the present invention, thereby facilitating injection into a chamber in a vapor state, facilitating precise deposition of a thin film by reducing a deposition rate, and ensuring that impurities do not remain in the thin film; and a semiconductor substrate and semiconductor device fabricated therefrom.

In addition, the azeotropic mixture according to the present invention, which can be used as a one-component type and does not have a pyrophoricity problem, can provide a GPC at a level of 0.15 Å/cycle (@450 °C) when a sufficient amount or an excessive amount is injected, so that thin film growth can be implemented by performing a 20-cycle process when depositing a target thickness of 3 Å. The azeotropic mixture provides a wide process margin to facilitate thickness control when forming an ultrathin film and can provide an advantage favorable for forming a continuous film.

### [Description of Drawings]

FIG. 1 is a diagram schematically showing a method of depositing a thin film using an azeotropic mixture according to Example 1 of the present invention.
FIG. 2 is a diagram showing NMR data of an azeotropic mixture according to Preparation Example 1 of the present invention.
FIG. 3 is a diagram showing NMR data of an azeotropic mixture according to Preparation Example 2 of the present invention.
FIG. 4 is a diagram showing results of measuring a temperature (T₀) at a point where weight loss ends for an azeotropic mixture according to Preparation Example 1 of the present invention and a volatility improver alone, respectively.
FIG. 5 is a diagram showing impurity analysis results by SIMS in a thin film formed in Example 1 using an azeotropic mixture according to Preparation Example 1 of the present invention, Comparative Example 1 using a volatility improver alone, or Comparative Example 4 including the same, respectively.
FIG. 6 is a diagram showing roughness measurement results measured by AFM in a thin film formed in Example 1 using an azeotropic mixture according to Preparation Example 1 of the present invention, Comparative Example 1 using a volatility improver alone, or Comparative Example 4 including the same, respectively.
FIG. 7 is a diagram showing a composition ratio of a thin film through AES measurement in a thin film formed in Example 2 using an azeotropic mixture according to Preparation Example 2 of the present invention, Comparative Example 1 using a volatility improver alone, or Comparative Example 4 including the same, respectively.
FIG. 8 is a diagram schematically showing the reason why electrical characteristics are reduced as a ratio of Al/O measured by AES in FIG. 7 exceeds 0.671, which is close to a stoichiometric value, and the value increases.

### [Best Mode]

Hereinafter, an azeotropic mixture of the present disclosure, a method of depositing a thin film using the azeotropic mixture, and a semiconductor substrate fabricated therefrom will be described in detail.

In the present disclosure, "azeotropic mixture" refers to a novel composition obtained by blending a volatility improver, which is not a reducing agent, with a precursor compound used in a deposition reaction, wherein the azeotropic mixture stabilizes volatility of the precursor compound so as not to increase a boiling point, has a characteristic that the precursor compound and the volatility improver are simultaneously volatilized, and may provide a synergistic effect of reducing/controlling a deposition rate.

In the present disclosure, unless otherwise specified, "modification" refers to an action that has a positive effect on formation of a metal film without having an adverse effect on adsorption of a central metal of a precursor compound onto a substrate for improvement of film quality such as reduction in resistivity, improvement in density, and reduction of impurities of a thin film.

In the present disclosure, unless otherwise mentioned, % refers to % by weight.

While continuing research on a technology capable of stabilizing highly flammable precursors represented by trimethyl aluminum (TMA), triethyl aluminum (TEA), dimethyl zinc (DMZ), diethyl zinc (DEZ), trimethyl gallium (TMG), triethyl gallium (TEG), trimethyl indium (TMI), and triethyl indium (TEI), the present inventors confirmed that when a predetermined compound was mixed with a precursor compound, low pyrophoricity or non-pyrophoricity was implemented to facilitate handling, and not only was simultaneous volatility exhibited, but also an ability to reduce or control a deposition rate of a thin film was implemented. Thus, the present inventors focused on related research to complete the present invention.

According to the present invention, an azeotropic mixture including a precursor compound having spontaneous pyrophoricity at room temperature; and a volatility modifier may be provided. In this case, there is an advantage in that handling is easy by implementing low pyrophoricity or non-pyrophoricity, and not only simultaneous volatility is exhibited, but also an ability to reduce or control a deposition rate of a thin film is implemented.

The precursor compound having spontaneous pyrophoricity at room temperature may be a known highly flammable precursor compound. 'Room temperature' is herein typically 20 to 25 °C.

For example, a central metal of the precursor compound may be aluminum, zinc, gallium, or indium.

The precursor compound may include one or more selected from trimethyl aluminum (TMA), triethyl aluminum (TEA), dimethyl zinc (DMZ), diethyl zinc (DEZ), trimethyl gallium (TMG), triethyl gallium (TEG), trimethyl indium (TMI), and triethyl indium (TEI).

For example, the physical properties of the precursor compound are shown in Table 1 below.

**[Table 1]**

| Abbreviations | Names | Chemical Formulas | Molecular weight | Melting point | Boiling point | Density | Refractive index |
|---|---|---|---|---|---|---|---|
| | | | (g/mol) | (°C) | (°C) | (g/cm²) | - |
| TMA | Trimethyl aluminum | Al(CH₃)₃ | 72.09 | 15 | 126 | 0.81 | N/A |
| TEA | Triethyl aluminum | Al(CH₂CH₃)₃ | 114.16 | -50 | 130 | 0.85 | N/A |
| DMZ | Dimethyl zinc | Zn(CH₃)₂ | 95.46 | -42 | 44 | 0.92 | N/A |
| DEZ | Diethyl zinc | Zn(CH₂CH₃)₂ | 123.51 | -28 | 98 | 1.205 | 1.498 |
| TMG | Trimethyl gallium | Ga(CH₃)₃ | 114.83 | -15.8 | 55.7 | 1.151 | N/A |
| TEG | Triethyl gallium | Ga(CH₂CH₃)₃ | 156.91 | -82.3 | 143 | 1.058 | N/A |
| TMI | Trimethyl indium | In(CH₃)₃ | 159.92 | 88 | 135.7 | 1.568 | Solid |
| TEI | Triethyl indium | In(CH₂CH₃)₃ | 202.00 | -31.9 | 184 | 1.26 | 1.538 |

*General Formula: M (Group 12)-L₂, M (Group 13)-L₃, and L is -CH₃, - CH₂CH₃, -CH₂CH₂CH₃, or -iPr

The precursor compound may be included within a range of 1 to 99 % by weight, 10 to 90 % by weight, or 30 to 70 % by weight of total components constituting the azeotropic mixture, and the amount is sufficient to exhibit the aforementioned synergistic effect.

The volatility modifier includes one or more compounds selected from a cyclic compound having 3 or more element species having a lone pair of electrons and a linear compound having 3 or more element species having a lone pair of electrons. In this case, there is an advantage of appropriately controlling volatility of the precursor compound, implementing low pyrophoricity or non-pyrophoricity, and providing storage stability at room temperature.

The lone pair of electrons may include one or more selected from oxygen (O), sulfur (S), phosphorus (P), and nitrogen (N).

The volatility modifier may include a linear or cyclic saturated hydrocarbon or a linear saturated hydrocarbon having 3 or more of nitrogen (N), oxygen (O), phosphorus (P), or sulfur (S) and having 3 to 15 carbon atoms. In this case, handling may be easy by implementing low pyrophoricity or non-pyrophoricity, and not only simultaneous volatility may be exhibited, but also an ability to reduce or control a deposition rate of a thin film may be implemented.

As a specific example, the cyclic compound having 3 or more element species having a lone pair of electrons may be a compound represented by Chemical Formula 1 below. In this case, volatility of the precursor compound may be appropriately controlled, low pyrophoricity or non-pyrophoricity may be implemented, and storage stability at room temperature may be provided.

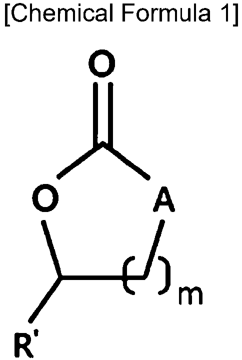

In Chemical Formula 1, R' is hydrogen, an alkyl group having 1 to 5 carbon atoms, an alkenyl group having 1 to 5 carbon atoms, or an alkoxy group having 1 to 5 carbon atoms,
A is oxygen (O), sulfur (S), phosphorus (P), or nitrogen (N), and
m is an integer of 0 to 2.

The linear compound having 3 or more element species having a lone pair of electrons may be a compound represented by Chemical Formula 2 below. In this case, volatility of the precursor compound may be appropriately controlled, low pyrophoricity or non-pyrophoricity may be implemented, and storage stability at room temperature may be provided.

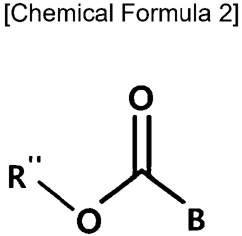

In Chemical Formula 2, R" is hydrogen, an alkyl group having 1 to 5 carbon atoms, an alkenyl group having 1 to 5 carbon atoms, or an alkoxy group having 1 to 5 carbon atoms, and
B is -OH, -OCH₃, -OCH₂CH₃, -CH₂CH₃, -SH, -SCH₃, or -SCH₂CH₃.

The volatility improver may include one or more compounds selected from compounds represented by Chemical Formulas 1-1 to 1-3 below and compounds represented by Chemical Formulas 2-1 to 2-3 below. In this case, volatility of the precursor compound may be appropriately controlled, low pyrophoricity or non-pyrophoricity may be implemented, and storage stability at room temperature may be provided.

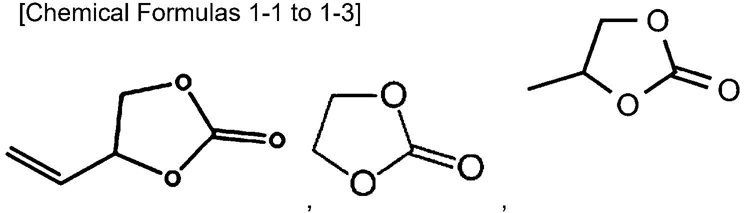

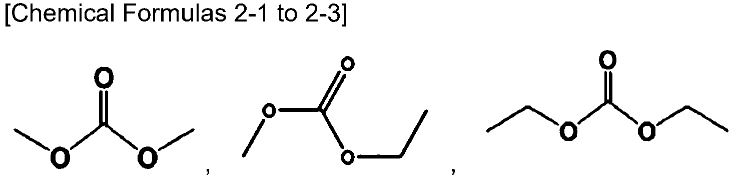

The volatility improver may be preferably a compound having a purity of 99.9% or more, a compound having a purity of 99.95% or more, or a compound having a purity of 99.99% or more. For reference, when a compound having a purity of less than 99% is used, impurities may remain in the thin film or side reactions with the precursor or reaction gas may be caused, so it is preferable to use a material having a purity of 99% or more.

The volatility improver may be included within a range of 1 to 99 % by weight, 10 to 90 % by weight, or 30 to 70 % by weight of total components constituting the azeotropic mixture, and the amount is sufficient to exhibit the aforementioned synergistic effect.

The precursor compound and the volatility improver may be included in, for example, a molar ratio of 1:0.5 to 5, and as a specific example, may be included in a molar ratio of 1:1 to 3.

The azeotropic mixture may have a boiling point within a range of 40 to 180 °C at normal pressure.

The azeotropic mixture may be lemon-colored or colored.

The azeotropic mixture may have a turbidity (haze) of 10 or less.

The turbidity was measured using a portable turbidity meter, and as the turbidity decreases to 10 or less, implementation of transparent physical properties in a deposited thin film using the azeotropic mixture is possible. When precipitation occurs due to a side reaction between the precursor compound and the mixed volatility improver, the azeotropic mixture may become a suspension. The suspension may block a narrow pipe or a capillary of LDS during a mass transfer process, and leads to particle contamination in a showerhead and a chamber, resulting in particle contamination on a semiconductor substrate, which may be a defect causing a fatal defect in a device. Due to this, it is important to check whether a precipitate is generated by measuring turbidity after sufficiently stirring the azeotropic mixture.

The azeotropic mixture may have a viscosity of 50 cP or less.

The viscosity was measured using a vibration type viscometer, and as the viscosity decreases to 50 cP or less, handleability is improved, and the viscosity of 50 cP or less is also preferable for reducing/controlling a deposition rate. When viscosity is high, there is a problem that transport of the azeotropic mixture is limited due to fluid resistance when passing through a narrow pipe or a capillary of an LDS.

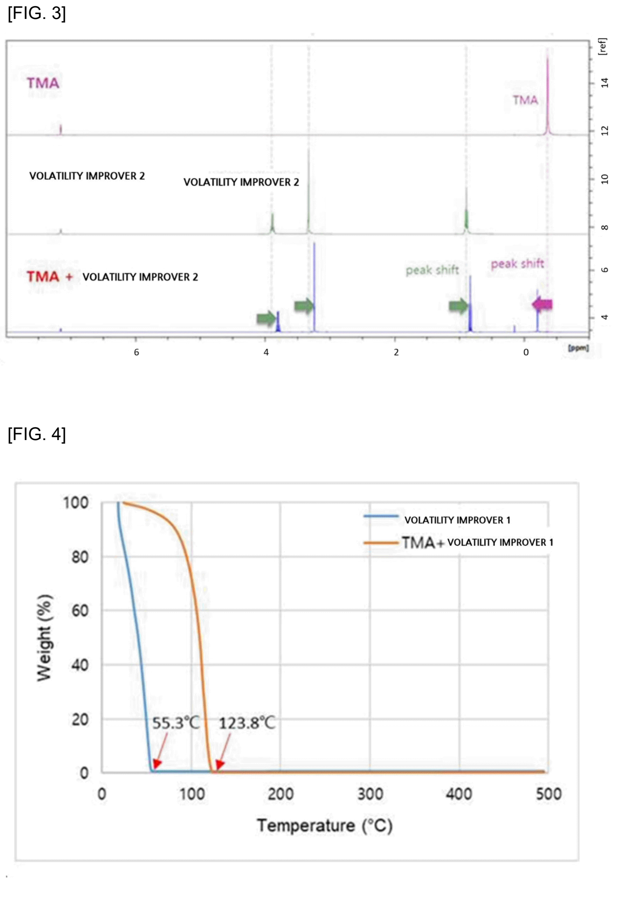

The azeotropic mixture may have a T₀ value of 200 °C or less. FIG. 4 below is a diagram showing results of measuring a temperature (T₀) at a point where weight loss ends for the azeotropic mixture according to Preparation Example 1 of the present invention and the volatility improver alone, respectively. As shown in FIG. 4 below, while a T₀ value of the volatility improver 1 (please describe a specific component name) alone is 55.3 degrees, the azeotropic mixture according to the present invention has a T₀ value of 123.8 degrees, which satisfies formation of a boiling point suitable for vaporization, so that it is possible to uniformly diffuse into a substrate and simultaneously reduce/control a deposition rate.

A method of depositing a thin film according to an embodiment of the present invention may include a step of stacking one or more thin films using the above-described azeotropic mixture.

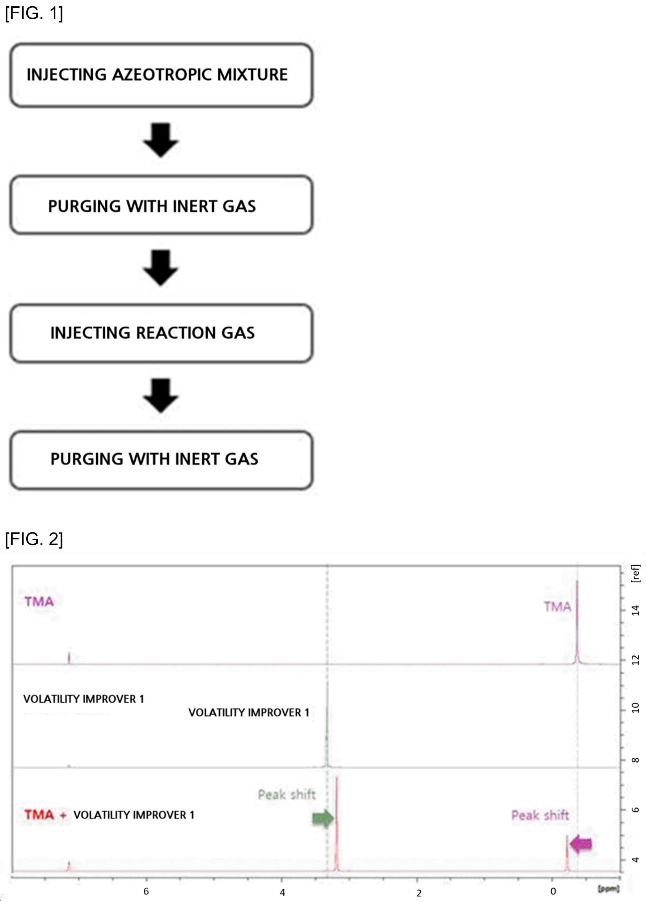

For example, the method of depositing a thin film reflects a process schematic shown in FIG. 1 below, and is characterized by including: a first step of implanting an azeotropic mixture (precursor) by injecting an azeotropic mixture having controlled pyrophoricity onto a substrate loaded in a chamber; a second step of removing an excessive amount of the azeotropic mixture and by-products by injecting an inert gas into the chamber; a third step of forming a nitride film, an oxide film, or a metal film of a central metal included in the precursor compound by injecting a nitriding gas, an oxidizing gas, or a reducing gas into the chamber; and a fourth step of removing unreacted gas and by-products by injecting an inert gas into the chamber. In this case, volatility of the precursor compound may be controlled while using conventional deposition equipment without modification, so that injection into the chamber in a vapor state may be easy, precise deposition of a thin film is easy by reducing a deposition rate, and a thin film in which impurities do not remain may be effectively provided.

In some cases, a multi-component alloy thin film may be formed. An indium oxide molecular layer may be formed by using a first azeotropic mixture (e.g., indium azeotropic mixture precursor) in the first step, undergoing a second step purging process, injecting a reactant (e.g., ozone) in the third step, and undergoing a fourth step purging process. Subsequently, a gallium oxide molecular layer may be formed by using a second azeotropic mixture (e.g., gallium azeotropic mixture precursor) in the first step, undergoing a second step purging process, injecting a reactant (e.g., ozone) in the third step, and undergoing a fourth step purging process. Subsequently, a zinc oxide molecular layer may be formed by using a third azeotropic mixture (e.g., zinc azeotropic mixture precursor) in the first step, undergoing a second step purging process, injecting a reactant (e.g., ozone) in the third step, and undergoing a fourth step purging process. An IGZO thin film may be formed by repeating this process in sequence. When performing the first to fourth steps of the first azeotropic mixture x times, the first to fourth steps of the second azeotropic mixture y times, and the first to fourth steps of the third azeotropic mixture z times, a composition ratio of an alloy layer may be controlled by making respective performance ratios equal to or different from each other. When the performance ratios are different, the following super cycle ratio is followed. When x is 10 times, y or z may be 1 to 9 times, when y is 10 times, x or z may be 1 to 9 times, and when z is 10 times, x or y may be 1 to 9 times.

The first step may be performed under an inert gas. In this case, an effect of reducing generation of by-products and improving a deposition rate may be exhibited.

The inert gas may be nitrogen, helium, or argon, and preferably has a purity of 4N to 9N to maximize the effect.

The cycle may be repeatedly performed until a metal film having a desired thickness is obtained by using the aforementioned first to fourth steps as a unit cycle. In this case, generated by-products are effectively removed, so that resistivity is reduced, step coverage is significantly improved, and there is an advantage of providing a deposition film having low resistance while improving film quality such as electrical characteristics and density while improving uniformity.

The chamber may be an ALD chamber, a CVD chamber, a PEALD chamber, or a PECVD chamber.

The substrate loaded in the chamber may be heated to 100 to 700 °C.

In the first step, the azeotropic mixture may be preferably transported into the chamber by a VFC method, a DLI method, or an LDS method, and is more preferably transported into the chamber by the LDS method.

The substrate loaded in the chamber may be heated to, for example, 100 to 700 °C, and as a specific example, 300 to 600 °C. The azeotropic mixture may be injected onto the substrate in an unheated state or a heated state, and depending on deposition efficiency, the azeotropic mixture may be injected unheated and then heating conditions may be adjusted during a deposition process. For example, the azeotropic mixture may be injected onto the substrate for 1 to 20 seconds at 50 to 400 °C.

Preferably, the method may include a step of raising a temperature in the chamber to a deposition temperature before introducing the azeotropic mixture into the chamber; and/or a step of purging by injecting an inert gas into the chamber before introducing the azeotropic mixture into the chamber.

The method may include a step of performing plasma post-treatment after the azeotropic mixture is vaporized and injected. In this case, by-products may be reduced while improving a film growth rate.

In the second step, an amount of the inert gas introduced into the chamber is not particularly limited as long as the amount is sufficient to remove the unreacted azeotropic mixture, but may be, for example, 10 to 10,000 times based on a volume of the azeotropic mixture introduced into the chamber, preferably 50 to 50,000 times, more preferably 100 to 10,000 times. Within this range, the unreacted azeotropic mixture is sufficiently removed so that the thin film is evenly formed and deterioration of film quality is be prevented. Here, input amounts of the inert gas and the azeotropic mixture are based on one cycle, respectively, and the volume of the azeotropic mixture refers to a volume of azeotropic mixture vapor.

In the third step, the reaction gas is supplied. The reaction gas is not particularly limited as long as the reaction gas is a reaction gas commonly used in the technical field to which the present invention belongs, and may preferably include a nitriding gas, an oxidizing gas, or a reducing gas. The reaction gas reacts with the central metal of the precursor compound adsorbed on the substrate to form a nitride film, an oxide film, or a metal film.

Preferably, the oxidizing gas is O₂, O₃, N₂O, NO₂, H₂O, or O₂ plasma.

The nitriding gas is N₂, N₂H₂, NH₃, or plasma thereof.

The reducing gas is H₂ or plasma thereof.

In the step of injecting the reaction gas onto a surface of the substrate, a feeding time (sec) of the reaction gas onto the surface of the substrate is preferably 0.01 to 10 seconds, more preferably 0.02 to 8 seconds, still more preferably 0.04 to 6 seconds, still more preferably 0.05 to 4 seconds per cycle. Within this range, there is an advantage that a film growth rate is low and step coverage and economic feasibility are excellent.

In the present disclosure, the feeding time of the reaction gas is based on a flow rate of 0.1 to 8,000 mg/cycle based on a chamber volume of 15 to 20 L, and more specifically, based on a flow rate of 10 to 5,000 mg/cycle in a chamber volume of 18 L.

Then, as a fourth step, purging is performed using an inert gas.

The purging is preferably performed at 1,000 to 50,000 sccm (Standard Cubic Centimeter per Minute), more preferably 2,000 to 30,000 sccm, still more preferably 2,500 to 15,000 sccm. Within this range, a film growth rate per cycle is appropriately controlled, and deposition is performed as or close to an atomic mono-layer or a molecular layer, which provides an advantage in terms of film quality.

The method of depositing a thin film may be performed at a deposition temperature in a range of, for example, 100 to 700 °C, and is preferably performed at a deposition temperature in a range of 200 to 500 °C . In this case, precise deposition is enabled by forming a thin film having a thickness of, for example, 0.05 (=0.5 Å) to 20 nm, preferably 0.07 to 15 nm, more preferably 0.1 to 13 nm, still more preferably 1.2 to 10 nm at a reduced deposition rate.

The method of depositing a thin film may be performed at a deposition pressure in a range of, for example, 0.01 to 20 Torr, preferably at a deposition pressure in a range of 0.1 to 20 Torr, more preferably at a deposition pressure in a range of 0.1 to 10 Torr, most preferably at a deposition pressure in a range of 0.3 to 7 Torr. Within this range, there is an effect of obtaining a metal film having a uniform thickness.

In the present disclosure, the deposition temperature and the deposition pressure may be measured as a temperature and a pressure formed in the deposition chamber, or may be measured as a temperature and a pressure applied to the substrate in the deposition chamber.

The unit cycle may be repeated to form a metal film having a desired thickness.

The unit cycle may be repeated, for example, 1 to 99,999 times, preferably 10 to 1,000 times, more preferably 50 to 5,000 times, and still more preferably 100 to 2,000 times. Within this range, there is an effect that desired film characteristics are well expressed.

As another example, the method of depositing a thin film reflects a process schematic shown in FIG. 2 below, and is characterized by including: step 2-1 of forming a deposition film of a central metal constituting a precursor compound by injecting the precursor compound and an azeotropic mixture onto a substrate loaded in a chamber to reduce the precursor compound while converting the precursor compound into a second gas; and step 2-2 of removing unreacted precursor compound, unreacted second gas, and by-products by injecting an inert gas into the chamber. In this case, there is an advantage of providing a method of depositing a thin film capable of providing a metal film having uniform thickness uniformity and improved resistance even when forming a metal film on a substrate having a complex structure due to impurity reduction, resistivity improvement, improvement of deposition characteristics, etc., while reducing process steps, and a semiconductor substrate fabricated therefrom.

Step 2-1 may be performed under an inert gas. In this case, an effect of reducing generation of by-products and improving a deposition rate may be exhibited.

The inert gas may be nitrogen, helium, or argon, and preferably has a purity of 4N to 9N to maximize the effect.

The cycle may be repeatedly performed until a metal film having a desired thickness is obtained by using the aforementioned steps 2-1 and 2-2 as a unit cycle, and when the film quality is improved by simultaneously introducing the azeotropic mixture with the precursor compound in one cycle as described above, generated by-products are effectively removed, so that resistivity is reduced, step coverage is significantly improved, and there is an advantage of providing a deposition film having low resistance while improving film quality such as electrical characteristics and density while improving uniformity.

The chamber may be an ALD chamber, a CVD chamber, a PEALD chamber, or a PECVD chamber.

The substrate loaded in the chamber may be heated to 100 to 700 °C.

In step 2-1, the precursor compound and a thin film modification composition may be preferably transported into the chamber by a VFC method, a DLI method, or an LDS method, and are more preferably transported into the chamber by the VFC method.

The substrate loaded in the chamber may be heated to, for example, 100 to 700 °C, as a specific example, 300 to 600 °C. The precursor compound or the azeotropic mixture may be injected onto the substrate in an unheated state or a heated state, and depending on deposition efficiency, the precursor compound or the azeotropic mixture may be injected unheated and then heating conditions may be adjusted during a deposition process. For example, the precursor compound or the azeotropic mixture may be injected onto the substrate for 1 to 20 seconds at 50 to 400 °C.

Preferably, the method may include a step of raising a temperature in the chamber to a deposition temperature before introducing the precursor compound and the thin film modification composition into the chamber; and/or a step of purging by injecting an inert gas into the chamber before introducing the precursor compound and the thin film modification composition into the chamber.

The method may include a step of performing plasma post-treatment after the precursor compound is vaporized and injected. In this case, by-products may be reduced while improving a film growth rate.

In the step of injecting the azeotropic mixture onto a surface of the substrate, a feeding time (sec) of the azeotropic mixture onto the surface of the substrate is preferably 0.01 to 10 seconds, more preferably 0.02 to 8 seconds, still more preferably 0.04 to 6 seconds, still more preferably 0.05 to 4 seconds per cycle. Within this range, there is an advantage that a film growth rate is low and step coverage and economic feasibility are excellent.

In the present disclosure, the feeding time of the azeotropic mixture is based on a flow rate of 0.1 to 8,000 mg/cycle based on a chamber volume of 15 to 20 L, and more specifically, based on a flow rate of 10 to 5,000 mg/cycle in a chamber volume of 18 L.

In step 2-2, an amount of the inert gas introduced into the chamber is not particularly limited as long as the amount is sufficient to remove the unreacted gas and by-products, but may be, for example, 10 to 10,000 times based on a volume of the precursor compound introduced into the chamber, preferably 50 to 50,000 times, more preferably 100 to 10,000 times. Within this range, the unreacted gas and by-products are sufficiently removed so that the thin film is evenly formed and deterioration of film quality may be prevented. Here, input amounts of the inert gas and the precursor compound are based on one cycle, respectively, and the volume of the precursor compound refers to a volume of precursor compound vapor.

In the present disclosure, the disclosed purging may be performed at preferably 1,000 to 50,000 sccm (Standard Cubic Centimeter per Minute), more preferably 2,000 to 30,000 sccm, and still more preferably 2,500 to 15,000 sccm. Within this range, a film growth rate per cycle is appropriately controlled, and deposition is performed as or close to an atomic mono-layer or a molecular layer, which provides an advantage in terms of film quality.

The method of depositing a thin film may be performed at a deposition temperature in a range of, for example, 100 to 700 °C, preferably at a deposition temperature in a range of 300 to 500 °C, more preferably at a deposition temperature in a range of 300 to 400 °C. Within this range, as described above, deposition characteristics, electrical characteristics, and film quality of the metal film may be improved without impurities through a powerful conversion effect to the second gas even in a lower process.

The method of depositing a thin film may be performed at a deposition pressure in a range of, for example, 0.01 to 20 Torr, preferably at a deposition pressure in a range of 0.1 to 20 Torr, more preferably at a deposition pressure in a range of 0.1 to 10 Torr, most preferably at a deposition pressure in a range of 0.3 to 7 Torr. Within this range, there is an effect of obtaining a metal film having a uniform thickness.

In the present disclosure, the deposition temperature and the deposition pressure may be measured as a temperature and a pressure formed in the deposition chamber, or may be measured as a temperature and a pressure applied to the substrate in the deposition chamber.

The unit cycle may be repeated to form a metal film having a desired thickness.

The unit cycle may be repeated, for example, 1 to 99,999 times, preferably 10 to 1,000 times, more preferably 50 to 5,000 times, still more preferably 100 to 2,000 times. Within this range, there is an effect that desired film characteristics are well expressed.

In the method of depositing a thin film, an intensity (c/s) of residual impurities (carbon or halogen element) in the metal film based on a metal film thickness of 100 Å, measured according to SIMS, may be preferably 100,000 or less, more preferably 70,000 or less, still more preferably 50,000 or less, still more preferably 10,000 or less, as a preferred example, 5,000 or less, still more preferably 10 to 4,000, still more preferably 10 to 3,000. Within this range, an effect of preventing deterioration of crystallinity and electrical characteristics is excellent.

The thin film obtained by the method of depositing a thin film according to the present invention may be a thin film in which one or more metal films, nitride films, or oxide films selected from Zn as a Group 12 metal and Al, Ga, and In as a Group 13 metal are stacked.

In addition, the present invention provides a thin film formed by the method of depositing a thin film described above, characterized in that the thin film is a thin film formed by stacking a nitride film, oxide film, or metal film of a central metal.

In the oxide film, a ratio of at least one Group 13 central metal selected from Al, Ga, and In/O (oxygen) as measured by AES may be within a range of 0.6 to 0.75.

In addition, in the oxide film, a ratio of a Group 12 central metal of Zn/O (oxygen) as measured by AES may be within a range of 0.45 to 0.55.

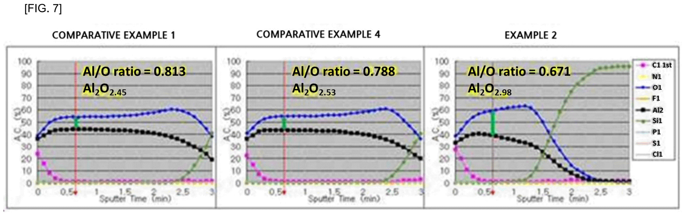

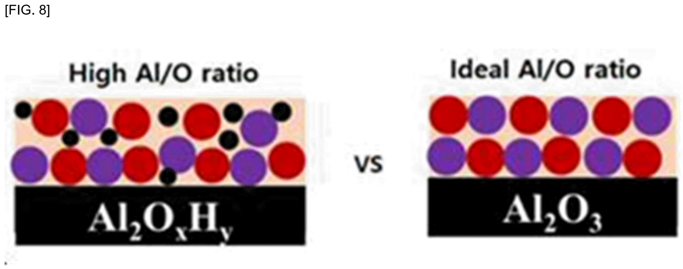

For example, in the case of AlₓO_{y}, it is suitable for 0.671, which is a stoichiometrically ideal AES measurement Al/O ratio, and when the ratio exceeds this, as shown in FIGS. 7 and 8 to be described later, carbon or hydrogen impurities may remain in the thin film. In this case, a problem of reduction in electrical characteristics such as a decrease in dielectric constant (k) and breakdown field (MV/cm) may occur.

As a specific example, in the oxide film, a ratio of at least one Group 13 central metal selected from Al, Ga, and In/O (oxygen) as measured by AES may be within a range of 0.6 to 0.75.

In addition, in the oxide film, a ratio of a Group 12 central metal of Zn/O (oxygen) as measured by AES may be within a range of 0.45 to 0.55.

The thin film may be an aluminum nitride film, an aluminum oxide film, an aluminum metal film, a zinc nitride film, a zinc oxide film, a zinc metal film, a gallium oxide film, a gallium nitride film, a gallium metal film, an indium oxide film, an indium nitride film, or an indium metal film.

The thin film may be variously used as a material for semiconductors, displays, solar cells, and secondary batteries generally used.

The thin film may be used in a semiconductor device for, for example, a wiring metal film or low resistance use.

The thin film may have a resistivity within a range of 5 µΩ·cm to 1000 µΩ·cm.

The thin film may contain, for example, 100 ppm or less of a halogen compound. For reference, when halogen remains excessively, for example, when a nitriding agent to be described later is used under a temperature condition of 200 to 300 °C, a chloride such as NH₄Cl is generated and remains in the metal film, which is not preferable.

In particular, while a relatively sparse film is formed, the growth rate of a film formed is significantly lowered, so that uniformity is secured even when applied to a substrate having a complex structure, enabling deposition with a particularly thin thickness. In addition, there is an effect of improving residual amounts of O, Si, metal, metal oxide, and carbon remaining as by-products, which were difficult to reduce in the related art.

In addition, the present invention may include a chamber, a vaporizer for vaporizing the azeotropic mixture to generate a precursor compound, a first transport means for transporting the vaporized azeotropic mixture into the chamber, and a second transport means for transporting a reaction gas into the chamber, as a manufacturing apparatus capable of providing the method of depositing a thin film. Here, the vaporizer and the transport means are not particularly limited as long as the vaporizer and the transport means are commonly used in the technical field to which the present invention belongs.

As a specific example, describing the method of depositing a thin film, first, a substrate on which a thin film is to be formed is placed in a chamber capable of deposition at an upper portion.

The substrate may include a semiconductor substrate such as a silicon substrate or silicon oxide.

A conductive layer or an insulating layer may be further formed on the substrate.

In order to deposit a thin film on the substrate placed in the deposition chamber, the above-described azeotropic mixture (a mixture of a precursor compound and a volatility improver) are prepared respectively.

Thereafter, the prepared azeotropic mixture is injected into a vaporizer, changed into a vapor phase, transferred to the deposition chamber according to the process shown in FIG. 1 below, and injected into the chamber, and unreacted materials or by-products are purged.

Then, a reaction gas is injected into the chamber to form a nitride film, an oxide film, or a metal film on the substrate, and then unreacted reaction gas or by-products are purged.

The thin film may have a deposition rate of 0.05 to 0.3 Å/cycle. Within this range, a precise thin film may be effectively provided.

In addition, the present invention provides a semiconductor substrate, and the semiconductor substrate is characterized by being manufactured by the method of depositing a thin film of the present invention, and in this case, film thickness uniformity is significantly excellent, and density and electrical characteristics are excellent.

The thin film preferably has a thickness of 30 nm or less, has a resistivity value of 5 to 2,000 µΩ·cm based on a thin film thickness of 10 nm, has an impurity content of 10,000 ppm or less, and has a step coverage of 90% or more. Within this range, performance as a diffusion barrier is excellent and an effect as a metal wiring material is excellent, but the present invention is not limited thereto.

The thin film may have a thickness of, for example, 0.05 (=0.5 Å) to 20 nm, preferably 0.07 to 15 nm, more preferably 0.1 to 13 nm, still more preferably 1.2 to 10 nm. Within this range, there is an effect that film characteristics are excellent.

The thin film may have a resistivity value of, for example, 0.1 to 400 µΩ·cm, preferably 0.1 to 200 µΩ·cm, more preferably 0.1 to 20 µΩ·cm based on a thin film thickness of 10 nm. Within this range, there is an effect that film characteristics are excellent.

The thin film may preferably have an impurity content of 10,000 ppm or less, or 1 to 9,000 ppm, still more preferably 1 to 8,500 ppm, and still more preferably 1 to 1,000 ppm. Within this range, there is an effect that film crystallinity is excellent and resistivity is improved. Here, the impurities remaining in the thin film are impurities remaining due to insufficient reduction of a metal precursor ligand, and may be, for example, carbon, nitrogen, oxygen, or a halogen element. As the residual amount of impurities in the thin film reduces, the film quality increases.

The thin film is characterized in that a ligand-derived film impurity content is reduced to 1% or less of impurities such as carbon when measured by XPS.

In the present disclosure, unless otherwise mentioned, the unit % refers to a weight basis.

The thin film has, for example, a step coverage of 90% or more, preferably 92% or more, more preferably 95% or more. Within this range, even a complex structure may be easily deposited on a substrate, so there is an advantage applicable to a next-generation semiconductor device.

The manufactured thin film preferably has a thickness of 20 nm or less, has an impurity content such as carbon, nitrogen, oxygen, and halogen of 10,000 ppm or less based on a metal film thickness of 10 nm, and has a step coverage of 90% or more. Within this range, there is an excellent effect as a metal wiring or a semiconductor device, but the present invention is not limited thereto.

The metal film is characterized in that crystallinity measured by XRD is improved.

Hereinafter, the present invention will be described in more detail with reference to the following preferred examples. However, these examples are provided for illustrative purposes only and should not be construed as limiting the scope and spirit of the present invention. In addition, it will be apparent to those skilled in the art that various changes and modifications may be made without departing from the spirit and scope of the present invention, and such changes and modifications are also within the scope of the appended claims.

### [Examples]

### Preparation Example 1

Trimethyl aluminum (TMA) was prepared as a precursor compound, and dimethyl carbonate (DMC) was prepared as a volatility improver 1 to prepare a mixture of the trimethyl aluminum (TMA) and the dimethyl carbonate (DMC).

An azeotropic mixture was prepared by blending the precursor compound and the volatility improver 1 at a weight ratio of 1:2.

A result of measuring NMR for the azeotropic mixture is shown in FIG. 2 below.

FIG. 2 below is a diagram showing NMR data of the azeotropic mixture according to Preparation Example 1 of the present invention.

As shown in FIG. 2 below, it was confirmed that a peak width between the precursor compound and the volatility improver 1 was reduced due to a peak shift, thereby generating a stable adduct.

### Preparation Example 2

Trimethyl aluminum (TMA) was prepared as a precursor compound, and diethyl carbonate (DEC) was prepared as a volatility improver 1 to prepare a mixture of the trimethyl aluminum (TMA) and the diethyl carbonate (DEC).

An azeotropic mixture was prepared by blending the precursor compound and the volatility improver 2 at a weight ratio of 1:2.

A result of measuring NMR for the azeotropic mixture is shown in FIG. 3 below.

FIG. 3 below is a diagram showing NMR data of the azeotropic mixture according to Preparation Example 2 of the present invention.

As shown in FIG. 3 below, it was confirmed that a peak width between the precursor compound and the volatility improver 1 was reduced due to a peak shift, thereby generating a stable adduct.

### [Test Examples]

Simultaneous volatilization was confirmed by measuring boiling points of the azeotropic mixtures obtained in Preparation Examples 1 and 2. Results are shown in Table 2 below.

In addition, APHA color value measurement, turbidity measurement, viscosity measurement, and T₀ value measurement were performed on the azeotropic mixtures obtained in Preparation Examples 1 and 2 and the volatility improvers 1 and 2 in the following manner.
*Turbidity measurement: The azeotropic mixtures obtained in Preparation Examples 1 and 2 and the volatility improvers 1 and 2 were measured after bottling in a glove box under an inert gas condition using a portable turbidity meter measurement method. Results are shown in Table 2 below.
*Viscosity measurement: The azeotropic mixtures obtained in Preparation Examples 1 and 2 and the volatility improvers 1 and 2 were measured in a glove box under an inert gas condition using a vibration type viscometer measurement method. Results are shown in Table 2 below.
*T₀ value measurement: The azeotropic mixtures obtained in Preparation Examples 1 to 2 and the volatility improvers 1 and 2 were measured by a temperature increasing method (ramp, 5 °C/min) of thermogravimetric analysis (TGA). Results are shown in Table 2 and FIG. 4 below.

The results of the boiling point measurement, the turbidity measurement, the viscosity measurement, and the T₀ value measurement measured above are summarized in Table 2 below.

**[Table 2]**

| Experiment | Precursor | Volatility improver | Turbidity | Viscosity (cP) | Vapor pressure (Torr @20 °C) | T₀ (°C) |
|---|---|---|---|---|---|---|
| Preparation Example 1 | TMA | Improver 1 | <3 | 0.9 | 4.8 | 123 |
| Preparation Example 2 | TMA | Improver 2 | <2 | 1.3 | - | - |
| Reference 1 | - | Improver 1 | <3 | 0.5 | 42 | 55.3 |
| Reference 2 | - | Improver 2 | <3 | 0.3 | 8.25 | - |

As shown in Table 2 and FIG. 4, it was confirmed that the azeotropic mixture of the present invention volatilizes simultaneously, reduces a boiling point, has high purity based on an APHA color value and turbidity, has a viscosity suitable for handling, and satisfies a temperature (T₀) at a point where weight loss ends of 180 degrees or less, which is a criterion capable of reducing/controlling a deposition rate while the azeotropic mixture is uniformly diffused into a substrate by satisfying formation of a boiling point suitable for vaporization.

For reference, FIG. 4 below is a diagram showing results of measuring a temperature (T₀) at a point where weight loss ends for the azeotropic mixture according to Preparation Example 1 of the present invention and a volatility improver alone, respectively.

### Examples 1 to 3, and Comparative Examples 1 to 6

A deposition process was performed using a process of FIG. 1 below. The azeotropic mixture obtained in Preparation Example 1 was used as the azeotropic mixture, and O₂ gas was used as a reaction gas. For reference, FIG. 1 below is a diagram showing a process schematic of a method of depositing a thin film using the azeotropic mixture according to Example 1 of the present invention.

Specific process sequences, and materials and contents used for each process are shown in Table 2 below.

For reference, a TMA injection amount of Comparative Examples 1 to 6 was 0.01 g/cycle (in a 10 L ALD chamber), an injection amount of an improver of Comparative Examples 4 to 6 was 0.01 g/cycle (in a 10 L ALD chamber), and an azeotropic mixture of Examples 1 to 3, which was blended as an azeotropic mixture (TMA:volatility improver 1 = 1:2 equivalent ratio) composed of trimethyl aluminum (TMA) and a volatility improver 1, was injected at 0.015 g/cycle (in a 10 L ALD chamber).

### [Test Examples]

For each thin film of Examples 1 to 3 and Comparative Examples 1 to 6 obtained, impurity content, analysis of types and contents of elements constituting a material surface, deposition rate measurement, crystal structure, orientation, and the like were confirmed in a manner as follows.
* SIMS (secondary-ion mass spectrometry) C impurities: A C impurity value was confirmed in a SIMS graph by considering a C impurity content (counts) when a sputter time is 50 seconds, at which contamination in a substrate skin layer is low, while digging into the thin film in an axial direction with an ion sputter.
* AES (Atomic emission spectroscopy) Al/O ratio: Auger electron spectroscopy analyzed a thin film composition in a depth direction while digging into the thin film in an axial direction with an ion sputter. Since a top layer of the substrate may be contaminated by fingerprints or the like during packaging and handling processes, a guideline was marked with a red grid line for a composition of the thin film at a corresponding depth after digging out the top layer until a sputter time of 0.6 minutes. A thin film composition of AlₓO_{y} is shown in FIG. 7 below by calculating a content ratio of aluminum (Al) element and oxygen (O) element.
* AFM (atomic force microscopy) roughness (Rq): A roughness value was measured by scanning the thin film for a 5 × 5 µm² area in a non-contact method with an atomic force microscope.
* Deposition rate (GPC) measurement: A deposition rate (GPC) was measured for each thin film of Examples 1 to 3 and Comparative Examples 1 to 6 obtained in a manner as follows. Specifically, a thickness of a thin film having a thickness range of 3 to 30 nm was measured using ellipsometer equipment, and the deposition rate was calculated by dividing the thickness by a number of deposition times, and a unit of Å/cycle is used.

**[Table 3]**

| Group | Experi ment | Precu rsor | Volat ility impr over | Reac tant | Process method | Deposi tion temper ature | GP C | GPC redu ction rate | C imp urity (c/s) | Rough ness (nm) |
|---|---|---|---|---|---|---|---|---|---|---|
| Compa rative Exampl e A | Compa rative Exampl e 1 | TMA | - | O₃ | S→P→R→ P | 250 | 0.8 4 | - | 420 | 0.148 |
| | Compa rative Exampl e 2 | TMA | - | O₃ | S→P→R→ P | 400 | 0.6 7 | - | - | - |
| | Compa rative Exampl e 3 | TMA | - | O₃ | S→P→R→ P | 450 | 0.6 5 | - | - | - |
| Compa rative Exampl e B | Compa rative Exampl e 4 | TMA | Impr over 1 | O₃ | S→P→A→ P→R→P | 250 | 0.5 6 | 34% | 364 | 0.117 |
| | Compa rative Exampl e 5 | TMA | Impr over 1 | O₃ | S→P→A→ P→R→P | 400 | 0.3 7 | 44% | - | - |
| | Compa rative Exampl e 6 | TMA | Impr over 1 | O₃ | S→P→A→ P→R→P | 450 | 0.2 9 | 55% | - | - |
| Exampl e | Exampl e 1 | TMA + improver 1 | | O₃ | (S+A)→P→ R→P | 150 | 0.2 333 | N/A | - | - |
| | | (1:2 equivalence ratio) | | | | | | | | |
| | Exampl e 2 | TMA + improver 1 (1:2 equivalence ratio) | | O₃ | (S+A)→P→ R→P | 300 | 0.1 5 | N/A | 43 | 0.104 |
| | Exampl e 3 | TMA + improver 1 (1:2 equivalence ratio) | | O₃ | (S+A)→P→ R→P | 450 | 0.1 27 | 80% | - | - |

In Table 3, abbreviation S denotes a precursor compound, abbreviation P denotes a purge, abbreviation R denotes an oxidizing gas, and abbreviation A denotes a volatility improver, respectively, and O₃ means ozone.

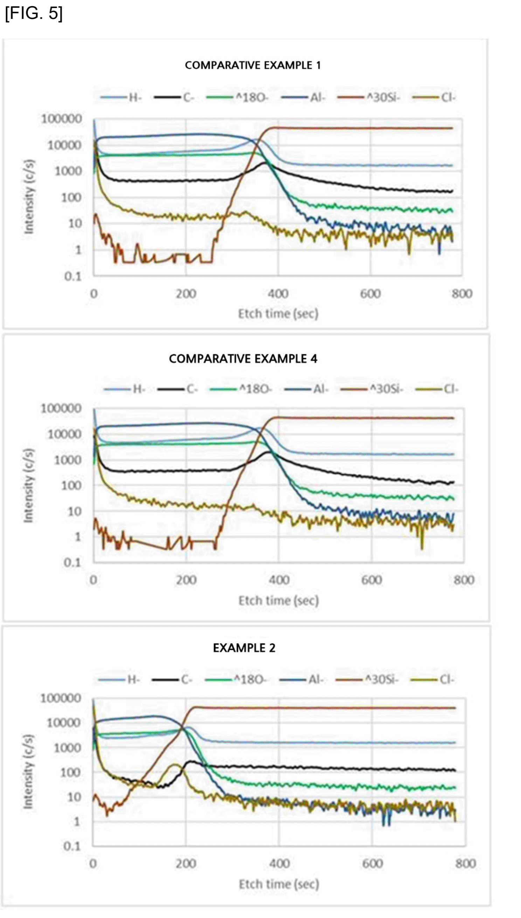

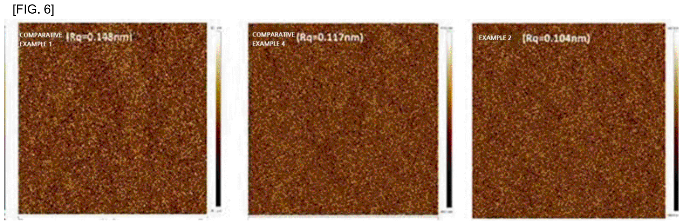

As shown in Table 3 and FIGS. 5 to 6 below, according to Example 1 using the azeotropic mixture according to the present invention, it may be confirmed that deposition rate reduction ability, electrical characteristics, film quality, surface characteristics, and impurity reduction characteristics are all effectively improved compared to Comparative Example 1 in which the volatility improver is excluded from the azeotropic mixture.

In addition, as shown in Table 3 and FIGS. 5 to 6 below, according to Example 1 using the azeotropic mixture according to the present invention, it may be confirmed that deposition rate reduction ability, electrical characteristics, film quality, surface characteristics, and impurity reduction characteristics are all effectively improved compared to Comparative Example 4 in which TMA and the volatility improver 1 are blended, respectively, not the azeotropic mixture.

For reference, in a ZAZ (ZrO₂/Al₂O₃/ZrO₂) multilayer film process, which is typical in a DRAM dielectric film process, a thickness of Al₂O₃ present between ZrO₂ is very thin. When the thickness of Al₂O₃ is excessively thin, capacitance decreases, and when the thickness of Al₂O₃ is excessively thick, there is a problem that electrical characteristics become poor.

In a general TMA + O₃ process, a level is 0.5 Å/cycle per cycle, and when a precursor injection amount is extremely reduced, the level may be reduced to a level of 0.3 Å/cycle, but there may be a trade-off problem in that it is difficult to secure a sufficient injection vapor amount required to reach the precursor to a lower portion of a pattern hole.

Due to this, a process within 10 cycles is required to deposit an Al₂O₃ thin film with a thickness of 0.5 nm (= 5 Å).

When depositing a thin film with a thinner thickness of 0.3 nm (= 3 Å), cycles are significantly reduced, so that control in a mass production process may become very difficult.

According to the present invention, the azeotropic mixture, which may be used as a one-component type and does not have a pyrophoricity problem, may provide a GPC at a level of 0.15 Å/cycle (@450 °C) when a sufficient amount or an excessive amount is injected, so that thin film growth may be implemented by performing a 20-cycle process when depositing a target thickness of 3 Å. The azeotropic mixture provides a wide process margin to facilitate thickness control when forming an ultrathin film and may provide an advantage favorable for forming a continuous film.

In addition, a composition of an AlₓO_{y} thin film was confirmed through AES measurement and is shown in FIG. 7 below. FIG. 7 below is a diagram showing a composition ratio of a thin film through AES measurement in a thin film formed in Example 2 using an azeotropic mixture according to Preparation Example 2 of the present invention, Comparative Example 1 using a volatility improver alone, or Comparative Example 4 including the same, respectively.

As shown in FIG. 7 below, the composition of the AlₖO_{y} thin film was confirmed through AES measurement. In the case of Comparative Example 1 in which the volatility improver was excluded from the azeotropic mixture, and Comparative Example 4 in which trimethyl aluminum (TMA) and the volatility improver 1 were blended respectively instead of the azeotropic mixture, when an Al/O ratio is expressed as a composition of 0.813 and 0.788, the composition resulted in Al₂O_{2.45} and Al₂O_{2.53}, which confirmed that the composition did not reach a stoichiometric value of Al₂O₃.

On the other hand, according to Example 2 using the azeotropic mixture according to the present invention, an Al/O ratio is 0.671, which is Al₂O_{2.98}, confirming that the thin film corresponds to Al₂O₃ as an ideal level of thin film close to the stoichiometric value.

In addition, when a ratio of Al/O exceeds 0.671, which is close to the stoichiometric value, and the value increases, carbon or hydrogen impurities may remain in the thin film as shown in a schematic diagram shown in FIG. 8 below. In this case, a problem of reduction in electrical characteristics such as a decrease in a dielectric constant (k) and a breakdown field (MV/cm) may occur.

Consequently, by blending a volatility improver with a precursor compound having high pyrophoricity among precursor compounds used to form a thin film on a substrate to control volatility of the precursor compound, injection into a chamber in a vapor state may be easy. In addition, it was confirmed that the azeotropic mixture is suitable for effectively reducing a deposition rate to precisely stack a thin film having a thin thickness while rapidly reducing ligand-derived impurities and improving physical properties such as roughness and crystallinity.

## Claims

1. An azeotropic mixture comprising a precursor compound having spontaneous pyrophoricity at room temperature; and a volatility modifier,
wherein a central metal of the precursor compound is at least one selected from Al, Zn, Ga, and In, and the volatility modifier is a material controlling volatility of the precursor compound and comprises one or more compounds selected from a cyclic compound having 3 or more element species having a lone pair of electrons and a linear compound having 3 or more element species having a lone pair of electrons.

2. The azeotropic mixture according to claim 1, wherein the precursor compound comprises one or more selected from the group consisting of Al(CH₃)₃, Al(CH₂CH₃)₃, Zn(CH₃)₂, Zn(CH₂CH₃)₂, Ga(CH₃)₃, Ga(CH₂CH₃)₃, In(CH₃)₃, and In(CH₂CH₃)₃, wherein the lone pair of electrons comprises one or more selected from oxygen (O), sulfur (S), phosphorus (P), and nitrogen (N).

3. The azeotropic mixture according to any preceding claim, wherein the cyclic compound having 3 or more element species having a lone pair of electrons is a compound represented by Chemical Formula 1 below. 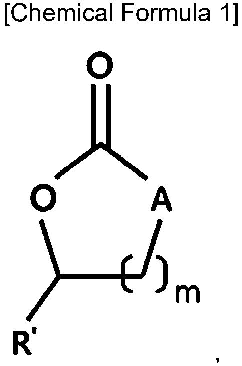 wherein R' is hydrogen, an alkyl group having 1 to 5 carbon atoms, an alkenyl group having 1 to 5 carbon atoms, or an alkoxy group having 1 to 5 carbon atoms, A is oxygen (O), sulfur (S), phosphorus (P), or nitrogen (N), and m is an integer of 0 to 2.

4. The azeotropic mixture according to any preceding claim, wherein the linear compound having 3 or more element species having a lone pair of electrons is a compound represented by Chemical Formula 2 below. 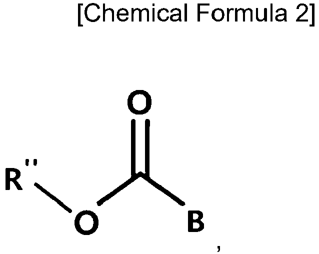 wherein R" is hydrogen, an alkyl group having 1 to 5 carbon atoms, an alkenyl group having 1 to 5 carbon atoms, or an alkoxy group having 1 to 5 carbon atoms, and B is -OH, -OCH₃, -OCH₂CH₃, -CH₂CH₃, -SH, -SCH₃, or -SCH₂CH₃.

5. The azeotropic mixture according to any preceding claim, wherein the volatility improver comprises one or more compounds selected from compounds represented by Chemical Formulas 1-1 to 1-3 below and compounds represented by Chemical Formulas 2-1 to 2-3 below.

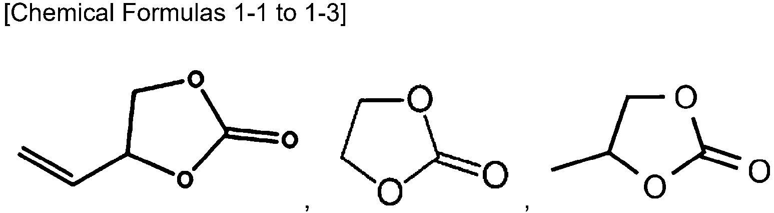

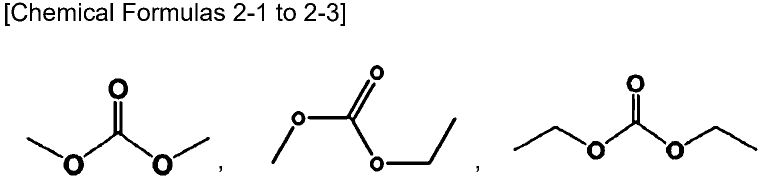

6. The azeotropic mixture according to any preceding claim, wherein the precursor compound and the volatility improver are comprised in a weight ratio of 1:0.5 to 5.

7. The azeotropic mixture according to any preceding claim, wherein the azeotropic mixture has a boiling point within a range of 40 to 180 °C, an APHA COLOR value of 5 or less as measured according to ASTM D 1209, a turbidity of 10 or less, and a viscosity of 50 cP or less, and simultaneously has a T₀ value of 200 °C or less.

8. A method of depositing a thin film, comprising stacking one or more thin films using the azeotropic mixture according to any one of claims 1 to 7.

9. The method according to claim 8, comprising:
injecting an azeotropic mixture onto a substrate loaded into a chamber to control spontaneous pyrophoricity of a precursor compound;
injecting an inert gas into the chamber to remove an unreacted azeotropic mixture and by-products;
injecting a nitriding gas, an oxidizing gas, or a reducing gas into the chamber to form a nitride film, oxide film, or metal film of a central metal comprised in the precursor compound; and
injecting an inert gas into the chamber to remove unreacted gas and by-products.

10. The method according to any of claims 8 to 9, wherein the substrate is heated to 100 to 700 °C, and the deposition is performed at 100 to 700 °C.

11. The method according to any of claims 8 to 10, wherein the thin film is formed by stacking an aluminum nitride film, an aluminum oxide film, an aluminum metal film, a zinc nitride film, a zinc oxide film, or a zinc metal film.

12. A thin film formed by the method of depositing a thin film according to any of claims 8 to 11, **characterized in that** the thin film is a thin film formed by stacking a nitride film, oxide film, or metal film of a central metal.

13. The thin film according to claim 12, wherein, in the oxide film, a ratio of at least one Group 13 central metal selected from Al, Ga, and In/O (oxygen) as measured by AES is within a range of 0.6 to 0.75.

14. The thin film according to any of claims 12 to 13, wherein, in the oxide film, a ratio of a Group 12 central metal of Zn/O (oxygen) as measured by AES is within a range of 0.45 to 0.55.

15. A semiconductor substrate comprising the thin film according to any of claims 12 to 14.
